# EUROPEAN PATENT APPLICATION

(11) **EP 2 833 545 A1**
(43) Date of publication of application: **04.02.2015**
(21) Application number: 13290180.2
(22) Date of filing: 01.08.2013
(51) Int. Cl.: H03B 5/36

(54) **Device and method for oscillation margin testing of a crystal oscillator**

(71) Applicant: NXP B.V., 5656 AG Eindhoven (NL)
(72) Inventor: Philip, Melaine, 5656 AG Eindhoven (NL)
(74) Representative: Krott, Michel

(57) **Abstract**

An integrated circuit for driving an oscillator has an amplifier and a feedback network connected to the amplifier. The feedback network comprises a variable resistor. The circuit has first and second terminals for connection to the oscillator crystal, a controller for controlling a setting of the variable resistor and a detector for detecting oscillation for one or more variable resistor settings.

This circuit thus provides an embedded system allowing the compatibility between an oscillator crystal and an integrated circuit used for driving the oscillator to be determined. This determination can be made for example in a customer application.

## Description

This invention relates to the testing of a crystal oscillator.

A crystal oscillator typically comprises an oscillator drive circuit and an oscillator crystal which is connected to the drive circuit.

The drive circuit provides a feedback path around the oscillator to provide the required oscillation. The crystal needs to be matched with the drive circuit in order to obtain stable oscillation. A poor match can result in a number of problems including start-up problems, insufficient drive frequency stability and even halting of the oscillation.

One example of crystal oscillator is a Pierce oscillator circuit. This is a well-known circuit and is widely used for its excellent frequency stability and the wide range of frequencies over which it can be used.

When designing a circuit for miniaturized quartz crystals, careful consideration must be given to the gain level of the drive circuit, and for this purpose it is required to check the match between the crystal and the drive circuit.

In particular, testing the oscillator performance is required to check if the oscillator gain margin is sufficient to allow crystal start-up and operation under all conditions and not too high so as to avoid crystal damage.

It is known to test the circuit function by measuring the circuit resistance, which needs to be negative for oscillations to be sustained. A known way to measure this resistance is by placing a variable resistor into the oscillator circuit. This variable resistor is external to the drive circuit, and the value of this resistor is tuned until the oscillation fails. The value of the tuned resistor then enables the circuit performance to determined, so that it can be determined if the oscillator will start up reliably and maintain stable oscillation, and this can be determined for different types of crystals and drive circuit.

This approach requires the external circuit to be modified during a testing phase, which is inconvenient for a designer when implementing a circuit using the oscillator. For example, oscillation margin testing requires a specific PCB so cannot be performed in the final customer application.

There is therefore a need for a testing approach which avoids the need for significant circuit modification as part of the test procedure.

According to the invention, there is provided an integrated oscillator drive circuit for coupling to an oscillator crystal, comprising:
an amplifier;
a feedback network connected to the amplifier, wherein the feedback network comprises a variable resistor;
first and second terminals for connection to the oscillator crystal;
a controller for controlling a setting of the variable resistor; and
a detector for detecting oscillation for one or more variable resistor settings.

This circuit provides a test circuit integrated with the oscillator drive circuit, which controls a variable resistor to enable the oscillator characteristics to be determined.

The detection is essentially based on a negative resistance test, and by embedding this into the integrated circuit providing the drive function, the negative resistance check can be performed in a customer application, without changing the PCB layout. This provides a lower effort for the end-customer when designing a system using the oscillator circuit.

The feedback network can comprise a fixed feedback resistor and the variable resistor. The fixed resistor provides the oscillator feedback function and the variable resistor provides the test function.

The circuit can comprise a third terminal. The fixed feedback resistor can be between the first and third terminals and the variable resistor can be between the second and third terminals. If the variable resistor is set to zero, the circuit becomes equivalent to the standard configuration, in that the second and third terminals are connected, so that the crystal oscillator and fixed feedback resistor are in parallel. The circuit essentially then has two terminals for connection to the oscillator crystal.

The controller is adapted to set the value of the variable resistor to:
a first value or set of values during a test mode;
a zero value during a normal operation mode.

Thus, in the normal operation mode, the circuit becomes equivalent to a standard circuit.

The first value or set of values in the test mode can for example include 3 times the effective series resistance of the oscillator crystal being used. The first value can for example be programmed by the end-customer to apply a test suitable for the particular oscillator crystal being used. The first value or set of values can (instead or additionally) include 5 times the effective series resistance of the oscillator crystal.

These values are the known measures to enable suitable stability and start-up performance to be determined.

The detector can comprise a peak detector for detecting the presence of oscillations.

The invention also provides an oscillator comprising:
an integrated oscillator drive circuit of the invention; and
an oscillator crystal connected between the first and second terminals.

This oscillator can be a Pierce oscillator. For this configuration, the oscillator further comprises first and second capacitors each connected between a respective side of the amplifier and ground.

The capacitors can be part of a passive integrated circuit which is connected to the integrated oscillator drive circuit within a system-in-package. A trimmed capacitor can be used.

The oscillator can be used in a near field communication system for generating a carrier frequency signal.

The invention also provides a method of testing compatibility between an integrated oscillator drive circuit and an oscillator crystal, with the oscillator crystal connected to the drive circuit, comprising:
setting the value of a variable resistor, which forms part of a feedback network connected to an amplifier within the integrated oscillator drive circuit, to a first value or a set of first values;
detecting oscillation for the one or more variable resistor settings; and
setting the variable resistor to a zero value for subsequent normal operation of the integrated oscillator drive circuit and oscillator crystal.

An example of the invention will now be described in detail with reference to the accompanying drawing, in which:
Figure 1 shows a known Pierce oscillator;
Figure 2 shows a known way to test the suitability of the oscillator crystal with the oscillator circuit;
Figure 3 shows in schematic form the approach of the invention for testing the suitability of the oscillator crystal with the oscillator circuit; and
Figure 4 shows an oscillator circuit with the testing capability of the invention in more detail.

The invention provides an integrated circuit for driving an oscillator, having an amplifier and a feedback network connected to the amplifier. The feedback network comprises a variable resistor. The circuit has first and second terminals for connection to the oscillator crystal, a controller for controlling a setting of the variable resistor and a detector for detecting oscillation for one or more variable resistor settings.

This circuit thus provides an embedded system allowing the compatibility between an oscillator crystal and an integrated circuit used for driving the oscillator to be determined. This determination can be made for example in a customer application.

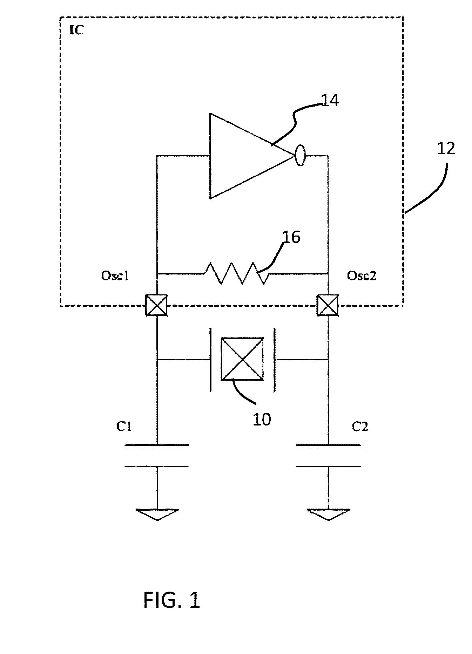

Figure 1 shows the known basic quartz crystal Pierce oscillator circuit. The circuit comprises the oscillator crystal 10 and a drive circuit. The drive circuit comprises an active integrated circuit 12 and a pair of capacitors C1, C2, which can be part of a passive integrated circuit or separate components. The active integrated circuit comprises an inverting amplifier 14 and a feedback network in the form of a resistor 16.

The active integrated circuit 12 has two terminals which connect to the opposite sides of the oscillator crystal, and the capacitors.

The oscillator crystal in combination with the two capacitors forms a band pass filter (with a pi configuration), which provides a 180 degree phase shift and a gain at the resonant frequency. The combination of the negative gain from the amplifier and the phase shift results in a positive overall loop gain, which gives rise to sustained oscillation.

For oscillation to occur, the Barkhausen criteria must be met:
- the loop gain must be equal to or greater than one;
- the phase shift around the loop must be equal to an integral multiple of 2.

While the crystal adds resistance to the oscillator circuit, the oscillator amplifier provides gain in the form of negative resistance. When the total circuit resistance is zero or negative, the oscillator will oscillate. When total circuit resistance becomes positive, the oscillator will fail.

It is well known that negative resistance testing gives a measure of the oscillator gain margin and the ability of the oscillator circuit to start.

Testing is performed at room temperature at a typical voltage.

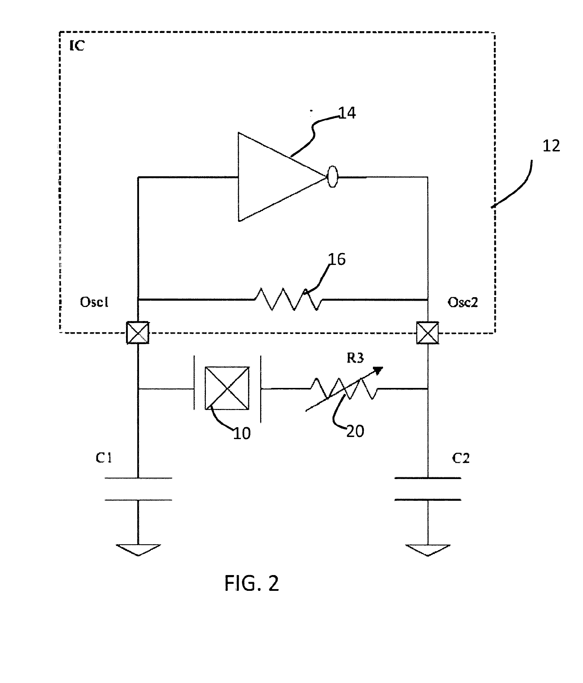

Figure 2 shows a typical test configuration. As shown in Figure 2, a variable resistance 20 with value R3 is inserted in series with the crystal and set to a minimum resistance. The oscillator is powered and allowed to start.

R3 is slowly increased until the oscillator just fails. The resistor R3 is then removed from the circuit and measured. The resistance is then compared to the crystal effective series resistance (ESR) as specified by the crystal manufacturer. The measured value of R3 should be several times the crystal Effective Series Resistance in order to provide sufficient gain to start the oscillator under all conditions. Typically, most industrial applications seek a factor of 3, while automotive applications seek a factor of at least 5.

This method requires reconfiguration of the oscillator circuitry, in particular it needs a change in the PCB layout of the end application in order to add a resistor in series with the crystal. For this reason, it is not suitable for testability of products in a customer application.

The invention provides a built-in system which is easy to implement in an end-customer application.

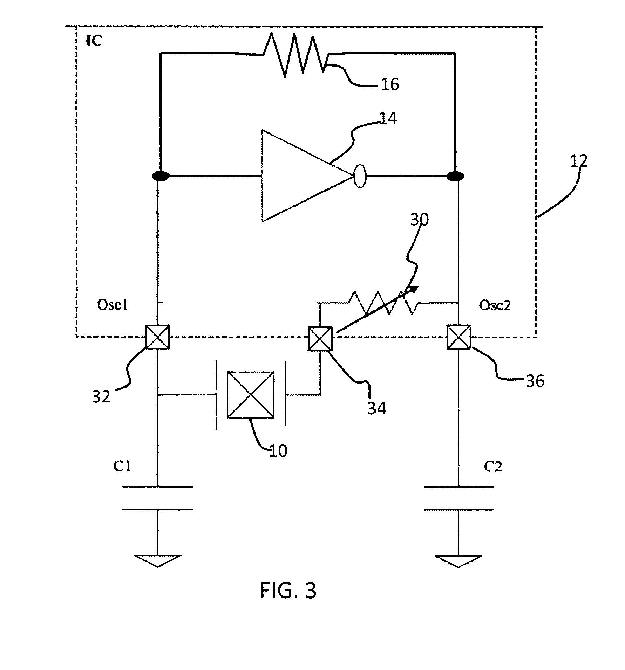

Figure 3 shows an oscillator circuit in accordance with the invention, and shows schematically the fundamental change to the approach of Figure 2.

The circuit comprises a variable resistor 30 (again shown with resistance value R3) which is embedded into the active integrated circuit 12.

The oscillation margin can be verified by using this embedded series resistor (on silicon). The active integrated circuit has an additional pin to allow the oscillator crystal to be connected differently to the capacitors.

In the example of Figure 3, the circuit comprises first and second terminals 32, 34 for connection to the oscillator crystal and a third terminal 36. The fixed feedback resistor 16 is between the first and third terminals and thus in a feedback path around the amplifier 14, and the variable resistor 30 is between the second and third terminals 34,36. The capacitors connect to the first and third terminals.

The value of the resistance is controlled and oscillation is detected for one or more variable resistor settings.

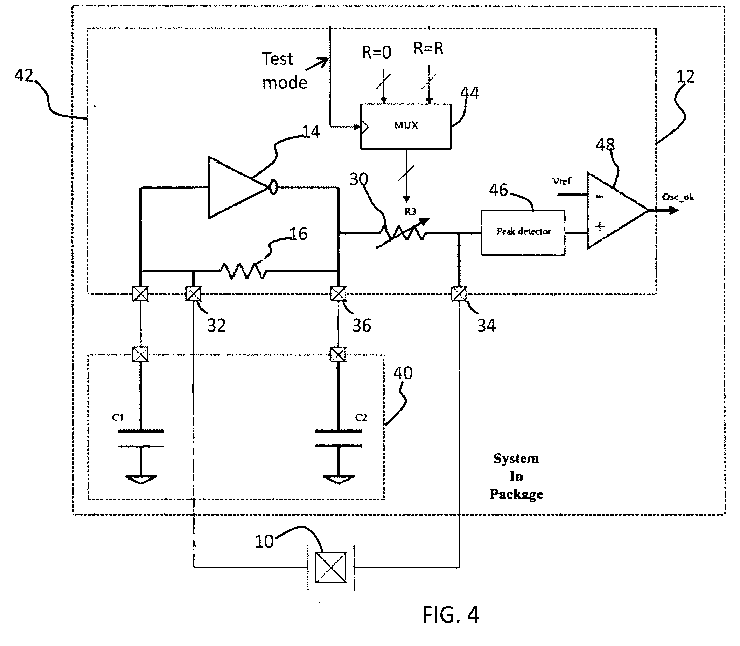

Figure 4 shows a more detailed example of circuit implementation.

In Figure 4, the circuit again comprises first and second terminals 32, 34 for connection to the oscillator crystal and a third terminal 36. The fixed feedback resistor 16 is again between the first and third terminals 32,36 and the variable resistor 30 is between the second and third terminals 34,36. The capacitors connect to the first and second terminals.

The variable resistor is in series with the crystal defining a feedback path of the amplifier, in addition to the normal feedback path comprising a fixed resistor in parallel with the amplifier.

When the value of R3 is set to zero, the circuit becomes equivalent to that shown in Figure 2. Thus, normal operation of the oscillator circuit can be obtained by setting R3=0.

R3 is set to non-zero values for a testing mode of operation.

In the example of Figure 4, the capacitors C1, C2 are part of a passive integrated circuit 40 which is connected to the active integrated oscillator drive circuit 12 within a system-in-package 42. Thus, the connection 32 is split into two in Figure 4, with one connection to the crystal oscillator and one to the capacitor passive IC 40. The oscillator crystal 10 is outside the system-in-package 42.

To perform the negative resistance test in an industrial application, the resistor R3 is set to a factor of 3 or 5 times the crystal Effective Series Resistance. A factor 5 is typically used for automotive applications. Figure 4 shows a multiplexer 44 which provides the control signal to the variable resistor 30. A test mode input controls the multiplexer 44, so when not in the test mode, the resistor is set to a zero value, and when in the test mode, the resistor is set to a desired value R, which can be programmed.

When the resistor is set to the desired value R, the crystal oscillator is enabled and the start-up behaviour is studied.

A peak detector 46 is used to measure a peak voltage on one terminal of the crystal. By comparing the peak voltage with a reference value Vref using comparator 48, oscillation can be detected. A signal Osc_ok is generated which indicates when oscillation is detected.

If the Osc_ok signal is at ground, the integrated oscillator drive circuit 12 is not compatible with the oscillator crystal ESR and the PCB layout.

If the Osc_ok signal is at the supply voltage level, the integrated oscillator drive circuit is compatible with the crystal ESR and the PCB layout.

No dedicated PCB is required for performing the oscillation margin test by the end-customer. The negative resistance check can be performed in the customer application, without changing in the PCB layout, which gives lower effort for the end-customer.

The system allows programmable negative resistor testing. The resistor value can be changed by software in the end-customer application.

The test can be for a single resistance value, or else multiple tests can be carried out for different resistance values (such as 3 times and 5 times the ESR of the crystal being used).

This invention is for example of interest in a Near Field Communication ("NFC") system. NFC is a new protocol of contactless communication in proximity distance, normalized by ISO18092. This communication is based on a 13.56MHz carrier frequency.

An NFC system can for example be embedded in a mobile phone, and the NFC front end then needs its own 27.12MHz micro crystal with small thickness, and therefore with high ESR. This high crystal ESR decreases the ability of the oscillator circuit to start. Negative resistance testing is then required in the mobile phone application to check the compatibility between the NFC integrated crystal oscillator drive circuit , the application PCB layout and the crystal ESR.

An analogue test bus can be embedded inside the circuit for controlling the test signals.

The invention is of particular interest for Pierce oscillator configurations, because they provide a simple to design architecture. However, the invention can be applied to other oscillator designs which require matching of the crystal to the oscillator circuit.

The example above is based on 27MHz oscillation. By way of example, the decoupling capacitances are about 10-20pF.

In the example above, the detection of oscillation is based on a peak detector and comparator. There are other forms of clock detector which can be used to detect oscillations, and which are known in other circuits.

The example above makes use of a multiplexer to control the variable resistor. There are of course other ways to control the resistor value, and the multiplexer function can be implemented as part of a processor which delivers a suitable output for controlling the variable resistor.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. An integrated oscillator drive circuit (42) for coupling to an oscillator crystal (10), comprising:
an amplifier (14);
a feedback network (16,30) connected to the amplifier, wherein the feedback network comprises a variable resistor (30);
first and second terminals (32,34) for connection to the oscillator crystal;
a controller (44) for controlling a setting of the variable resistor; and
a detector (46,48) for detecting oscillation for one or more variable resistor settings.

2. A circuit as claimed in claim 1, wherein the feedback network comprises a fixed feedback resistor (16) and the variable resistor (30).

3. A circuit as claimed in claim 2, wherein the circuit comprises a third terminal (36), wherein the fixed feedback resistor (16) is between the first and third terminals (32,36) and the variable resistor (30) is between the second and third terminals (34,36).

4. A circuit as claimed in any preceding claim, wherein the controller (44) is adapted, with the drive circuit coupled to an oscillator crystal, to set the value of the variable resistor to:
a first value or set of values during a test mode;
a zero value during a normal operation mode.

5. A circuit as claimed in claim 4, wherein the first value or set of values includes 3 times the effective series resistance of the oscillator crystal.

6. A circuit as claimed in claim 4 or 5, wherein the first value or set of values includes 5 times the effective series resistance of the oscillator crystal.

7. A circuit as claimed in any preceding claim, wherein the detector comprises a peak detector (46) for detecting the presence of oscillations.

8. An oscillator comprising:
an integrated oscillator drive circuit (42) as claimed in any preceding claim; and
an oscillator crystal (10) connected between the first and second terminals.

9. A Pierce oscillator comprising an oscillator as claimed in claim 8, wherein the oscillator further comprises first and second capacitors (C1,C2) each connected between a respective side of the amplifier (14) and ground.

10. An oscillator as claimed in claim 9, wherein the capacitors are part of a passive integrated circuit (40) which is connected to the integrated oscillator drive circuit (42) within a system-in-package.

11. A near field communication system comprising an oscillator as claimed in claim 9 or 10 for generating a carrier frequency signal.

12. A method of testing compatibility between an integrated oscillator drive circuit (42) and an oscillator crystal (10), with the oscillator crystal connected to the drive circuit, comprising:
setting the value of a variable resistor (30), which forms part of a feedback network connected to an amplifier (14) within the integrated oscillator drive circuit, to a first value or a set of first values;
detecting oscillation for the one or more variable resistor settings; and
setting the variable resistor to a zero value for subsequent normal operation of the integrated oscillator drive circuit and oscillator crystal.

13. A method as claimed in claim 12, wherein the first value or set of values includes 3 times and/or 5 times the effective series resistance of the oscillator crystal.

14. A method as claimed in claim 12 or 13, wherein detecting oscillations comprises using a peak detector for detecting the presence of oscillations.
